# DEMANDE DE BREVET EUROPEEN

(11) **EP 1 313 219 A1**
(43) Date de publication de la demande: **21.05.2003**
(21) Numéro de dépôt: 02079725.4
(22) Date de dépôt: 13.11.2002
(51) Int. Cl.: H03H 17/06

(54) **Convertisseur numérique de fréquence d'échantillonnage**

(30) Priorité: 20.11.2001 FR 0115001
(71) Demandeur: Koninklijke Philips Electronics N.V., 5621 BA Eindhoven (NL)
(72) Inventeur: Pasquier, Laurent, Société Civile S.P.I.D., 75008 Paris (FR)
(74) Mandataire: Chaffraix, Jean

(57) **Abrégé**

La présente invention concerne un convertisseur de signal numérique d'entrée (1) en un signal numérique de sortie (3) à partir d'un ensemble de coefficients de filtrage. Le convertisseur comprend des moyens de filtrage réalisant une fonction de filtrage et fournissant l'ensemble de coefficients de filtrage à partir de déphasages (2) entre un échantillon du signal numérique de sortie et des échantillons du signal numérique d'entrée, la fonction de filtrage étant définie par un ensemble de polynômes. Les moyens de filtrage comprennent en outre une mémoire (52) pour stocker des coefficients des polynômes, et des moyens de calcul (53) de l'ensemble de coefficients de filtrage à partir des coefficients des polynômes et des déphasages. Un tel convertisseur permet un grand nombre de conversions de format, tout en disposant de ressources mémoire limitées.

## Description

### Domaine technique de l'invention

La présente invention concerne un convertisseur de signal numérique d'entrée en un signal numérique de sortie à partir d'un ensemble de coefficients de filtrage, ledit convertisseur comprenant des moyens de filtrage aptes à réaliser une fonction de filtrage et à fournir un coefficient de filtrage à partir d'un déphasage entre un échantillon du signal numérique de sortie et un échantillon du signal numérique d'entrée.

Elle concerne également un procédé de conversion du signal numérique d'entrée en un signal numérique de sortie.

Elle trouve notamment son application dans les récepteurs numériques de télévision, par exemple lors d'une conversion du format d'image.

### Etat de la technique antérieure

Dans de nombreux systèmes vidéo, il est souvent nécessaire d'effectuer une conversion d'un signal numérique d'entrée d'une première fréquence d'échantillonnage vers une seconde fréquence d'échantillonnage, selon le format d'image requis par le dispositif de réception. Une telle conversion résulte en un agrandissement ou une réduction de l'image d'origine correspondant à un sur-échantillonnage ou un sous-échantillonnage de ladite image.

Dans un système tout numérique conventionnel, la conversion s'effectue en trois étapes principales. Dans une première étape, un filtre d'interpolation permet de sur-échantillonner le signal numérique d'entrée échantillonné à une fréquence f1 afin d'obtenir un signal intermédiaire échantillonné à une fréquence f3 telle que f3 = k.f2, k étant un entier et f2 étant la fréquence d'échantillonnage souhaitée en sortie du convertisseur. Dans une seconde étape, un filtre passe-bas est appliqué sur le signal intermédiaire afin de garantir le théorème de Shannon. Enfin, lors d'une troisième étape, une décimation du signal ainsi filtré est effectuée afin d'obtenir un signal de sortie échantillonné à la fréquence f2.

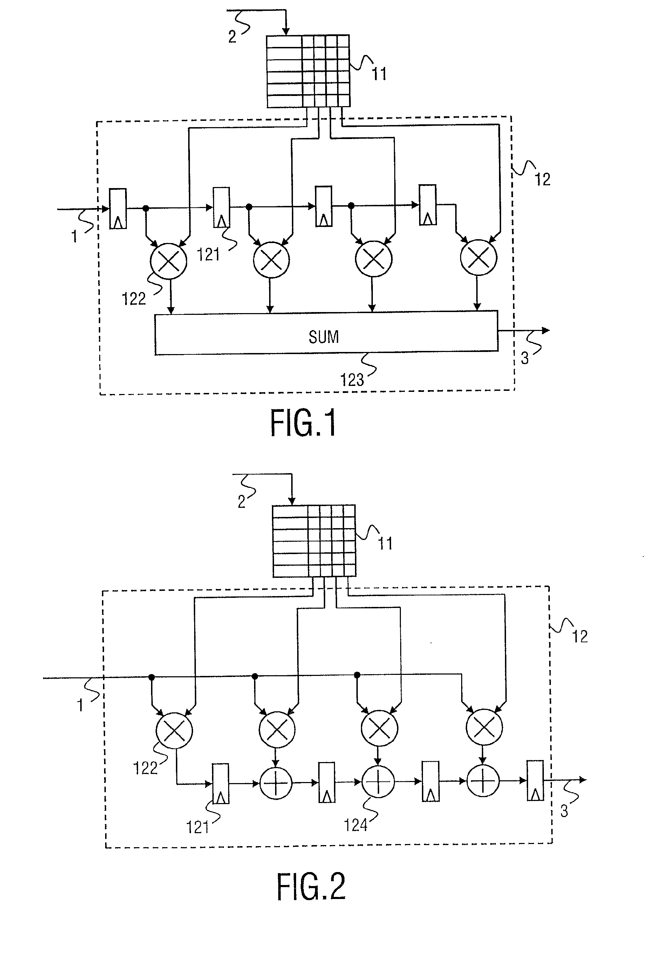

Ces trois étapes peuvent avantageusement être mises en oeuvre grâce à un filtre de à réponse impulsionnelle finie FIR à structure polyphase. Un tel filtre à 4 coefficients (en anglais 'taps') est décrit aux Figs. 1 et 2, respectivement en mode de fonctionnement direct et inverse. Il comprend un convolueur (12) apte à fournir un signal numérique de sortie (3) échantillonné à une fréquence f2 à partir d'un signal numérique d'entrée (1) échantillonné à une fréquence f1 et d'un ensemble de 4 coefficients de filtrage. Ledit ensemble de coefficients de filtrage est issu d'une mémoire (11) contenant, pour chaque déphasage entre un échantillon du signal numérique de sortie et un échantillon du signal numérique d'entrée, un ensemble de coefficients de filtrage. Des moyens de calcul non représentés ici permettent en outre de calculer le déphasage entre un échantillon du signal numérique de sortie et un échantillon du signal numérique d'entrée. Dans le mode direct de fonctionnement, le convolueur comprend des registres à décalage (121) aptes à décaler un échantillon, et un dispositif de sommation SUM (123) apte à additionner les produits d'un échantillon décalé par un coefficient de filtrage, lesdits produits étant issus de multiplieurs (122). Dans le mode inverse de fonctionnement, le convolueur comprend 4 multiplieurs (122) aptes à effectuer le produit d'un coefficient de filtrage par un échantillon courant du signal numérique d'entrée. La sortie d'un premier multiplieur est reliée à l'entrée d'un premier registre à décalage (121). Un premier additionneur (124) effectue une somme de la sortie du premier registre à décalage et d'un second multiplieur et fournit ladite somme à un second registre à décalage. Un second additionneur effectue une somme de la sortie du second registre à décalage et d'un troisième multiplieur et fournit cette somme à un troisième registre à décalage. Un troisième additionneur effectue une somme de la sortie du troisième registre à décalage et d'un quatrième multiplieur et fournit un échantillon du signal numérique de sortie (3).

Le brevet canadien délivré sous le numéro CA 2,144,111 décrit une méthode de conversion telle que décrite dans le paragraphe introductif. Cette méthode utilise un filtre à réponse impulsionnelle finie FIR à structure polyphase de même structure que celle précédemment décrite, et comprenant notamment un banc mémoire contenant des ensembles de coefficients de filtrage. Ces ensembles de coefficients de filtrage sont pré-calculés pour différentes valeurs de déphasage, le nombre de déphasage possible étant limité par la taille du banc mémoire. Or, plus un filtre possède de valeurs de déphasage différentes, plus il peut effectuer de conversions de format différentes. Autrement dit, les performances d'un filtre polyphase sont étroitement liées à la taille de sa mémoire. Il résulte donc qu'un filtre polyphase tel que défini dans l'état de la technique antérieure n'est capable de gérer qu'un nombre limité de conversions de format ce qui limite ses performances.

### Exposé de l'invention

La présente invention a pour but de proposer un procédé et un dispositif de conversion d'un signal numérique d'entrée en un signal numérique de sortie, qui soit plus performant en permettant notamment de gérer un plus grand nombre de valeurs de déphasage, donc un plus grand nombre de conversions de format, tout en disposant de ressources mémoire limitées.

A cet effet, le convertisseur selon l'invention est remarquable en ce que la fonction de filtrage est définie par un ensemble de polynômes, et en ce que les moyens de filtrage comprennent une mémoire apte à stocker des coefficients des polynômes, et des moyens de calcul aptes à calculer l'ensemble de coefficients de filtrage à partir des coefficients des polynômes et des déphasages entre un échantillon du signal numérique de sortie et des échantillons du signal numérique d'entrée.

Ainsi, le convertisseur selon l'invention dispose d'une mémoire où sont seulement stockés les coefficients des polynômes approximant par parties la fonction de filtrage. Dans le cas d'une fonction de filtrage approximée par 4 polynômes du troisième degré, seuls 16 coefficients sont stockés. Les moyens de calcul permettent ensuite de calculer les coefficients de filtrage à partir des coefficients des polynômes et des déphasages entre des échantillons d'entrée et l'échantillon de sortie. Ce calcul est particulièrement simple à mettre en oeuvre dans le cas de polynômes.

En outre, la présente invention présente l'avantage de permettre de façon simple des conversions de format à facteur d'échelle variable. De telles conversions sont particulièrement utiles pour représenter des images en perspective.

### Brève description des dessins

Ces aspects de l'invention ainsi que d'autres aspects plus détaillés apparaîtront plus clairement grâce à la description suivante de plusieurs modes de réalisation de l'invention, donnés à titre d'exemples non limitatifs et en regard des dessins annexés parmi lesquels :
- la Fig. 1 est un diagramme représentant le fonctionnement en mode direct d'un filtre polyphase à 4 coefficients selon l'état de la technique antérieure,
- la Fig. 2 est un diagramme représentant le fonctionnement en mode inverse d'un filtre polyphase à 4 coefficients selon l'état de la technique antérieure,
- la Fig. 3a est un diagramme représentant un circuit de calcul du déphasage entre un échantillon du signal numérique de sortie et un échantillon du signal numérique d'entrée,
- la Fig. 3b illustre le résultat d'un tel calcul dans le cas d'un facteur d'échelle égal à 4/5,
- la Fig. 4 illustre une fonction de filtrage passe-bas dans le domaine spatial et son approximation par parties par des polynômes, et
- la Fig. 5 est un diagramme représentant le fonctionnement en mode direct d'un filtre à 4 coefficients selon l'invention.

### Exposé détaillé d'au moins un mode de réalisation de l'invention

La présente invention concerne un convertisseur d'un signal numérique d'entrée en un signal numérique de sortie, comprenant un filtre de type filtre à structure polyphase. Elle a été développée dans le cas d'une conversion de format de données vidéo, le signal numérique comprenant des échantillons de type pixels mais reste applicable à d'autres types de données comme les données audio par exemple. Dans le cas de données vidéo, les valeurs de pixels qui sont filtrées sont, par exemple, les données de luminance ou de chrominance.

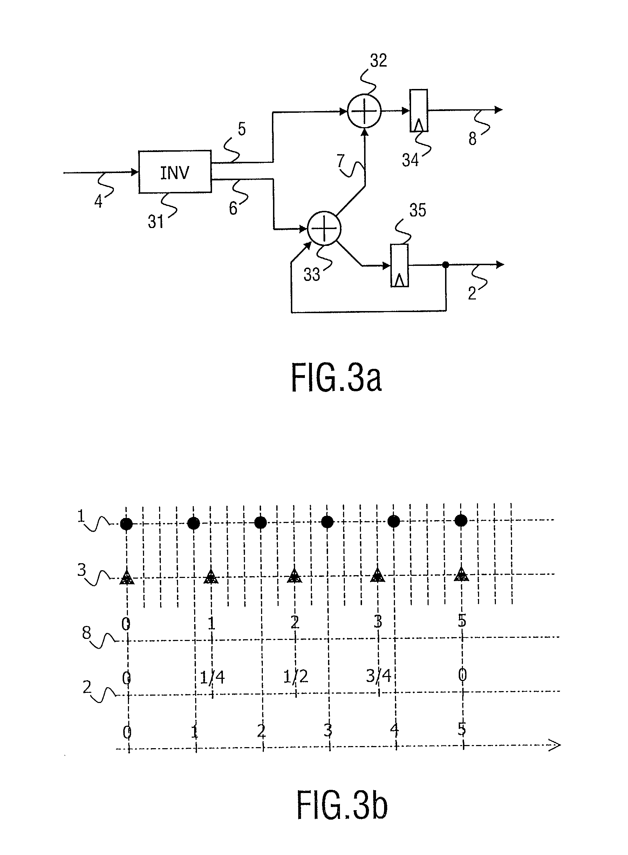

Le terme polyphase indique une représentation périodique des déphasages entre un échantillon du signal numérique d'entrée, un pixel dans le cas d'un signal vidéo, et un échantillon du signal numérique de sortie. Ces déphasages sont calculés en fonction d'un facteur d'échelle ou facteur de zoom z selon le principe de la Fig. 3a.

Le circuit de calcul de ladite figure est apte à recevoir le facteur d'échelle z (4), et comprend des moyens d'inversion et de séparation (31) aptes à inverser le facteur d'échelle et à fournir une partie entière (5) et une partie fractionnaire (6) du facteur d'échelle inversé 1/z. La partie entière est délivrée à une première entrée d'un premier additionneur (32) et la partie fractionnaire est délivrée à une première entrée d'un second additionneur (33). Le premier additionneur est également apte à recevoir sur une seconde entrée une retenue (7) issue du second additionneur et à fournir la somme de la retenue et de la partie entière à un premier registre à décalage (34), lui-même chargé de fournir une position entière (8) du pixel dans une ligne ou colonne de l'image. La sortie du second additionneur est reliée à un second registre à décalage (35), ce dernier étant chargé de fournir une position fractionnaire du pixel dans une ligne ou colonne de l'image, cette position fractionnaire correspondant au déphasage (2). La position fractionnaire est également reliée à une seconde entrée du second additionneur.

L'exemple de la Fig. 3b illustre le fonctionnement du circuit de calcul dans le cas d'un facteur de zoom égal à 4/5, correspondant donc à un rapport de la fréquence f2 du signal numérique de sortie sur la fréquence f1 du signal numérique d'entrée égal à 4/5. Les premiers pixels des signaux numériques d'entrée et de sortie sont confondus. Le facteur d'échelle inversé est égal à 1.25 correspondant à une partie entière de 1 et une partie fractionnaire de 1/4. Le déphasage étant initialement de 0, la retenue est égale à 0 et la position entière est par conséquent de 1 et le déphasage de 1/4. En recommençant l'opération, on obtient un ensemble périodique de déphasages égal à {0 1/4 1/2 3/4}.

Le convertisseur selon l'invention comprend des moyens de filtrage aptes à réaliser une fonction de filtrage et à fournir un ensemble de coefficients de filtrage pour un déphasage donné parmi l'ensemble périodique des déphasages. Comme nous l'avons vu précédemment, les coefficients de filtrage sont complexes à générer, et il est avantageux d'avoir des ensembles de coefficients de filtrage pré-calculés, la somme des coefficients de filtrage d'un ensemble étant égale à 1. Ainsi, les coefficients de filtrage sont générés seulement une fois. Un filtre polyphase conventionnel est apte à gérer 64 déphasages ce qui peut s'avérer nettement insuffisant, notamment dans le domaine vidéo où un utilisateur peut vouloir effectuer un réglage fin de la taille d'une image sur un moniteur vidéo, un récepteur de télévision par exemple. Par exemple, si un utilisateur veut qu'une image constituée de lignes de 640 pixels devienne une image constituée de lignes de 641 pixels, 641 déphasages différents sont nécessaires, ce qui nécessiterait le stockage de 641 jeux de coefficients, et impliquerait donc un encombrement important de la mémoire du filtre polyphase.

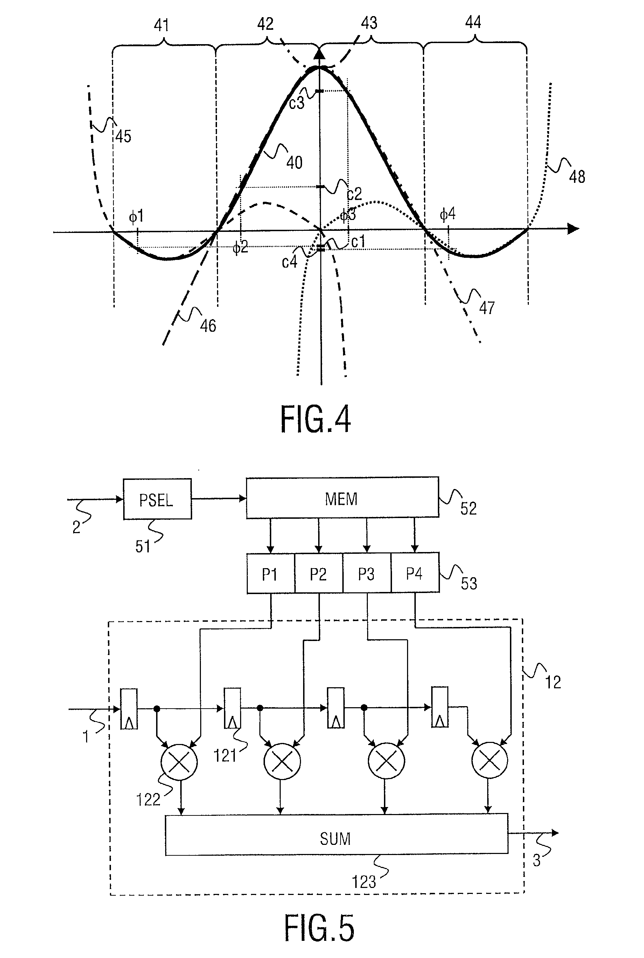

C'est pourquoi la fonction de filtrage du convertisseur selon l'invention est approximée par un ensemble de polynômes. La Fig. 4 illustre une fonction de filtrage passe-bas dans le domaine spatial et son approximation par parties par des polynômes. La présente invention n'est cependant pas limitée à ce type de fonction de filtrage et peut s'appliquer, par exemple, à des fonctions de filtrage où les fréquences f1 du signal d'entrée et f2 du signal de sortie sont égales, ou encore à des fonctions de filtrage passe-haut pour une segmentation. La fonction de filtrage (40) est ici un sinus cardinal sinc(x)=sin(πx)/(πx) borné. L'inconvénient de la fonction de filtrage sinc() non bornée est que tous les pixels d'entrée contribuent à la reconstruction d'un pixel de sortie courant. La fonction de filtrage passe-bas est approximée par un ensemble de polynômes (en anglais 'splines'). Dans l'exemple de la Fig. 4, ces polynômes sont au nombre de 4, chaque polynôme (45 à 48) correspondant à un intervalle de 1 pixel (41 à 44).

Seuls les coefficients des polynômes approximant par parties la fonction de filtrage, soit 16 coefficients dans notre exemple, sont alors gardés en mémoire et les coefficients de filtrage sont calculés à la volée à partir des coefficients des polynômes quelle que soit la valeur du déphasage. Des polynômes du troisième ordre sont de préférence utilisés et une approximation de la fonction de filtrage par un ensemble de 4 polynômes s'avère généralement suffisante mais il apparaîtra à l'homme du métier que d'autres polynômes et ensembles de polynômes sont également possibles.

La Fig. 5 est un diagramme représentant le fonctionnement en mode direct d'un filtre à 4 coefficients selon l'invention. Le filtre polyphase comprend tout d'abord des moyens de sélection PSEL (51) aptes à sélectionner les polynômes en fonction des déphasages (2) entre les pixels d'entrée et le pixel de sortie. Les coefficients des polynômes sélectionnées sont alors stockés dans une mémoire MEM (52). Le filtre polyphase comprend alors des moyens de calculs P1 à P4 (53) aptes à calculer un ensemble de coefficients de filtrage à partir des coefficients des polynômes pour les différents déphasages (2). Par exemple, pour des déphasages φ1 à φ4 représentés à la Fig. 4, 4 coefficients de filtrages c1 à c4 sont déterminés par les moyens de calcul. Un coefficient de filtrage est calculé à partir du déphasage entre le pixel de sortie et un des pixels d'entrée. Tous les polynômes ne sont donc pas forcément utilisés à chaque fois, notamment lors d'une forte réduction du format de l'image. Un convolueur tel que décrit à la Fig. 1 permet alors de convertir un signal numérique d'entrée (1) échantillonné à une première fréquence en un signal numérique de sortie (3) échantillonné à une seconde fréquence à partir des coefficients de filtrage ainsi calculés à la volée.

Outre le réglage fin de la dimension d'une image, le procédé et le dispositif de conversion selon l'invention peuvent être utilisés avec des facteurs de zoom variables, par exemple pour convertir une image d'un format 16/9 vers un format 4/3. A chaque pixel de l'image est associé un facteur de zoom horizontal et vertical, les facteurs de zoom pouvant différer d'un pixel à un autre. Ainsi, pour convertir une image d'un format 16/9 vers un format 4/3, les facteurs de zoom horizontaux des pixels situés dans une zone centrale de l'image sont proches de 1 et les facteurs de zoom horizontaux des pixels situés vers des bords d'images sont plus importants. De la sorte, l'image est relativement peu déformée et il y a relativement peu de pertes d'informations. Il est également possible de tirer partie des facteurs de zoom variables pour corriger d'autres défauts géométriques tels que, par exemple, une distorsion en trapèze.

La présente invention concerne également un procédé de conversion d'un signal numérique d'entrée en un signal numérique de sortie à partir d'un ensemble de coefficients de filtrage. Ledit procédé comprend une étape de filtrage utilisant une fonction de filtrage et destinée à fournir l'ensemble de coefficients de filtrage à partir de déphasages entre un échantillon du signal numérique de sortie et des échantillons du signal numérique d'entrée, la fonction de filtrage étant définie par un ensemble de polynômes. L'étape de filtrage comprend en outre une sous-étape de mémorisation destinée à stocker des coefficients des polynômes, et une sous-étape de calcul destinée à calculer l'ensemble de coefficients de filtrage à partir des coefficients des polynômes et des déphasages.

Aucun signe de référence entre parenthèses dans le présent texte ne doit être interprété de façon limitative. Le verbe "comprendre" et ses conjugaisons doivent également être interprétés de façon large, c'est à dire comme n'excluant pas la présence non seulement d'autres éléments ou étapes que ceux listés après ledit verbe, mais aussi d'une pluralité d'éléments ou d'étapes déjà listés après ledit verbe et précédés du mot "un" ou "une".

## Revendications

1. Convertisseur de signal numérique d'entrée (1) en un signal numérique de sortie (3) à partir d'un ensemble de coefficients de filtrage, ledit convertisseur comprenant des moyens de filtrage aptes à réaliser une fonction de filtrage et à fournir un coefficient de filtrage à partir d'un déphasage (2) entre un échantillon du signal numérique de sortie et un échantillon du signal numérique d'entrée, **caractérisé en ce que** la fonction de filtrage est définie par un ensemble de polynômes, et **en ce que** les moyens de filtrage comprennent une mémoire (52) apte à stocker des coefficients des polynômes, et des moyens de calcul (53) aptes à calculer l'ensemble de coefficients de filtrage à partir des coefficients des polynômes et des déphasages entre un échantillon du signal numérique de sortie et des échantillons du signal numérique d'entrée.

2. Convertisseur de signal numérique d'entrée (1) selon la revendication 1, **caractérisé en ce qu'**il comprend des moyens de sélection (51) aptes à sélectionner les polynômes en fonction des déphasages (2) entre des échantillons du signal numérique d'entrée et un échantillon du signal numérique de sortie.

3. Procédé de conversion d'un signal numérique d'entrée (1) en un signal numérique de sortie (3) à partir d'un ensemble de coefficients de filtrage, ledit procédé comprenant une étape de filtrage utilisant une fonction de filtrage et destinée à fournir un coefficient de filtrage à partir d'un déphasage (2) entre un échantillon du signal numérique de sortie et un échantillon du signal numérique d'entrée, **caractérisé en ce que** la fonction de filtrage est définie par un ensemble de polynômes, et **en ce que** l'étape de filtrage comprend une sous-étape de mémorisation destinée à stocker des coefficients des polynômes, et une sous-étape de calcul destinée à calculer l'ensemble de coefficients de filtrage à partir des coefficients des polynômes et des déphasages entre un échantillon du signal numérique de sortie et des échantillons du signal numérique d'entrée.

4. Procédé de conversion de signal numérique d'entrée (1) selon la revendication 3, **caractérisé en ce qu'**il comprend une étape de sélection des polynômes en fonction des déphasages (2) entre des échantillons du signal numérique d'entrée et un échantillon du signal numérique de sortie.

5. Moniteur vidéo comprenant un convertisseur selon la revendication 1.
